(19) Europäisches Patentamt / European Patent Office / Office européen des brevets

(11) **EP 3 787 382 A1**

(12) **EUROPEAN PATENT APPLICATION**
published in accordance with Art. 153(4) EPC

(43) Date of publication:
**03.03.2021 Bulletin 2021/09**

(51) Int Cl.:
***H05K 1/02*** (2006.01)

(21) Application number: **19867831.0**

(22) Date of filing: **09.09.2019**

(86) International application number:
**PCT/CN2019/104929**

(87) International publication number:
**WO 2020/063313 (02.04.2020 Gazette 2020/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.09.2018 CN 201811125833**

(71) Applicant: **ZTE Corporation**
**Shenzhen, Guangdong 518057 (CN)**

(72) Inventors:
• **YIN, Changgang**
  **Shenzhen, Guangdong 518057 (CN)**
• **CAO, Huazhang**
  **Shenzhen, Guangdong 518057 (CN)**
• **WANG, Yingxin**
  **Shenzhen, Guangdong 518057 (CN)**

(74) Representative: **Vinsome, Rex Martin et al**
**Urquhart-Dykes & Lord LLP**
**The Core**
**Bath Lane**
**Newcastle Helix**
**Newcastle upon Tyne and Wear NE4 5TF (GB)**

(54) **CIRCUIT BOARD, SIGNAL CROSSTALK SUPPRESSION METHOD, STORAGE MEDIUM, AND ELECTRONIC DEVICE**

(57)    Provided is a circuit board, a signal crosstalk suppression method, a storage medium and an electronic device. The circuit board includes: a circuit board body, provided with a signal via-hole structure, a ground via-hole structure and a slotted structure; the signal via-hole structure is configured to transmit a signal by changing a layer, and the ground via-hole structure is configured to return a signal transmitted from the signal via-hole structure; the slotted structure is provided between the signal via-hole structure and the ground via-hole structure, and configured to suppress a signal crosstalk of the signal via-hole structure. According to the present disclosure, the problem of via-hole crosstalk suppression is solved, and the effect of reducing the crosstalk of an interference signal to a victim signal is achieved.

FIG. 1

**Description**

## TECHNICAL FIELD

The present disclosure relates to the field of electricity, in particular to a circuit board, a signal crosstalk suppression method, a storage medium and an electronic device.

## BACKGROUND

At present, high-speed products have a transmission rate increased from 10Gbps to 25Gbps or even 56Gbps, which makes the signal integrity requirement of high-speed interconnection channels stricter and stricter. There are two main factors that affect the performance of high-speed interconnection channels, one is the insertion loss of interconnection channels, and the other is crosstalk between signals. With the increase of signal rate, crosstalk of the same magnitude may cause greater performance degradation. Therefore, crosstalk suppression is an inevitable direction of high-speed interconnection design. One region where the interference between signals on the circuit board is serious and difficult to suppress is a via-hole, especially a via-hole of a fan-out region and a via-hole of a connector region of a ball grid array (BGA).

The crosstalk has three elements, i.e., an interference source, a coupling path and a victim signal. From the perspective of the coupling path, methods for suppressing crosstalk include: increasing a distance between the interference source and the victim signal, and adding a ground isolated via-hole between the interference source and the victim signal.

For BGA chips in a fixed package, the former may not reduce the crosstalk by increasing a distance between a fan-out via-hole of the victim signal and a fan-out via-hole of the interference signal, while the latter may not add the ground isolated via-hole between the fan-out via-hole of the victim signal and the fan-out via-hole of the interference signal due to space constraints in some high-density packages. With the further increase of the rate, the limitations of these two methods become more and more obvious.

In view of the above technical problems, relevant technologies have not yet put forward effective solutions.

## SUMMARY

Embodiments of the present disclosure provides a circuit board, a signal crosstalk suppression method, a storage medium and an electronic device, to at least solve the problem of via-hole crosstalk suppression in related technologies.

According to an embodiment of the present disclosure, a circuit board is provided, which includes: a circuit board body, provided with a signal via-hole structure, a ground via-hole structure and a slotted structure. The signal via-hole structure is configured to transmit a signal by changing a layer, and the ground via-hole structure is configured to return the signal transmitted from the signal via-hole structure; the slotted structure is provided between the signal via-hole structure and the ground via-hole structure, and configured to suppress a signal crosstalk of the signal via-hole structure.

Optionally, the circuit board body includes: a conductor layer, including a plurality of conductors; and a dielectric layer, including a plurality of dielectrics. The conductors included in the conductor layer and the dielectrics included in the dielectric layer are configured in the circuit board body in a cross-stacked manner.

Optionally, the signal via-hole structure includes: a layer-changing via-hole for victim differential signal, configured for a layer-changing transmission for a victim differential signal; and a layer-changing via-hole for interference differential signal, configured for a layer-changing transmission for an interference differential signal.

Optionally, the ground via-hole structure includes a plurality of ground via-holes.

Optionally, the slotted structure is configured between the signal via-hole structure and the ground via-hole structure; and the slotted structure includes a plurality of slots, and the plurality of slots are respectively configured between the layer-changing via-hole for victim differential signal and the ground via-hole, and between the layer-changing via-hole for interference differential signal and the ground via-hole.

Optionally, the slotted structure is filled with a high permittivity dielectric, and the high permittivity dielectric includes a dielectric with a higher permittivity than a permittivity of the circuit board body.

Optionally, one of the following is included: the slotted structure is provided extending from a top layer of the conductor layer to a bottom layer of the conductor layer; or the slotted structure is provided extending from the top layer of the conductor layer to any position between the top layer and the bottom layer of the conductor layer.

According to another embodiment of the present disclosure, a signal crosstalk suppression method is further provided, including: suppressing a signal crosstalk of a signal via-hole structure by using a slotted structure provided between the signal via-hole structure and a ground via-hole structure; wherein the signal via-hole structure and the ground via-hole structure are provided in a circuit board, the signal via-hole structure is configured to transmit a signal by changing a layer, and the ground via-hole structure is configured to return the signal transmitted from the signal via-hole structure.

According to another embodiment of the present disclosure, a storage medium is provided, which stores a computer program, and the computer program is set to execute the steps in any of the above method embodiments at runtime.

According to another embodiment of the present disclosure, an electronic device is provided, which includes a memory and a processor. The memory stores a computer program, and the processor is set to run the computer program to execute the steps in any of the above method embodiments.

According to the present disclosure, since the slotted structure is provided between the signal via-hole structure and the ground via-hole structure, the crosstalk may also be reduced even in BGA chips in a fixed package and high-speed and high-density single boards. Therefore, the problem of via-hole crosstalk suppression may be solved, and the effect of reducing the crosstalk of an interference signal to a victim signal is achieved.

## BRIEF DESCRIPTION OF THE DRAWINGS

The accompanying drawings described here are used to provide a further understanding of the present disclosure and constitute a part of the present disclosure. The illustrative embodiments of the present disclosure and their descriptions are provided to explain the present disclosure, and do not constitute an improper limitation on the present disclosure. In the accompanying drawings:

FIG. 1 is a schematic structural diagram of a circuit board in an embodiment of the present disclosure;
FIG. 2 is a block diagram of a preferred structure of a circuit board according to an embodiment of the present disclosure;
FIG. 3 is a first cross-sectional view of a circuit board according to an embodiment of the present disclosure;
FIG. 4 is a second cross-sectional view of a circuit board according to an embodiment of the present disclosure;
FIG. 5 is a third cross-sectional view of a circuit board according to an embodiment of the present disclosure;
FIG. 6 is a fourth cross-sectional view of a circuit board according to an embodiment of the present disclosure;
FIG. 7 is an effect diagram according to an embodiment of the present disclosure;
FIG. 8 is a flowchart of a signal crosstalk suppression method according to an embodiment of the present disclosure.

## DETAILED DESCRIPTION

The present disclosure will be described in detail with reference to the accompanying drawings and embodiments. It should be noted that the embodiments in the present disclosure and the features in the embodiments may be combined with each other on the premise of no contradiction.

It should be noted that the terms "first", "second", etc. in the specification, claims and the above accompanying drawings of the present disclosure are set to distinguish similar objects, and need not be set to describe a specific order or sequence.

An embodiment of the present disclosure provides a circuit board, including: a circuit board body, provided with a signal via-hole structure and a ground via-hole structure. The signal via-hole structure is configured to transmit a signal by changing a layer, and the ground via-hole structure is configured to return the signal transmitted from the signal via-hole structure.

The circuit board further includes a slotted structure, provided between the signal via-hole structure and the ground via-hole structure, and configured to suppress a signal crosstalk of the signal via-hole structure.

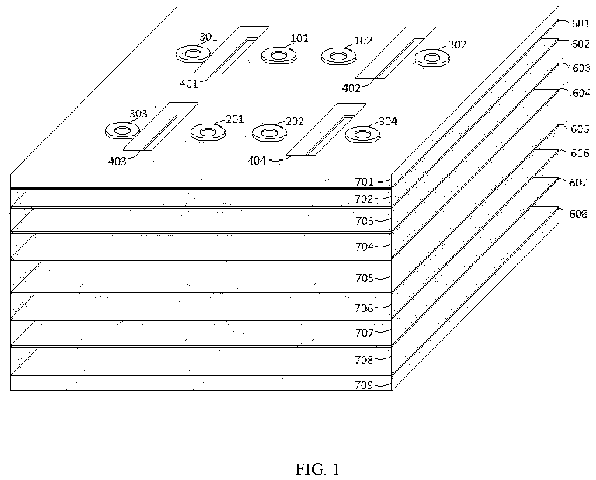

In this embodiment, the above-described circuit board may be a printed circuit board (PCB); and the above-described circuit board body has multiple layers. FIG. 1 is a schematic structural diagram of the circuit board in this embodiment. As shown in FIG. 1, the circuit board mainly includes a conductor layer and a dielectric layer. The conductor layer includes a plurality of conductors (601-608); the dielectric layer includes a plurality of dielectrics (701-709); and the conductors included in the conductor layer and the dielectrics included in the dielectric layer are configured in the circuit board body in a cross-stacked manner.

Optionally, as shown in FIG. 1, the signal via-hole structure mainly includes: a layer-changing via-hole for victim differential signal (101 and 102), configured for a layer-changing transmission of the victim differential signal; and layer-changing via-hole for interference differential signal (201 and 202), configured for a layer-changing transmission of the interference differential signal. The ground via-hole structure includes a plurality of ground via-holes (301 - 304).

Optionally, the slotted structure includes a plurality of slots (401-404), and the plurality of slots are respectively configured between the layer-changing via-holes for victim differential signal and the ground via-hole, and between the layer-changing via-holes for interference differential signal and the ground via-hole. That is, the slotted structure 401 is formed between 101 and 301, the slotted structure 402 is formed between 102 and 302, the slotted structure 403 is formed between 201 and 303, and the slotted structure 404 is formed between 202 and 304.

Optionally, the slotted structure is filled with a high permittivity dielectric. The high permittivity dielectric includes a dielectric with a higher permittivity than a permittivity of the circuit board body. The crosstalk of an interference signal to a victim signal is reduced, and the processing difficulty and reliability are reduced.

Optionally, the slotted structure extends from a top layer of the conductor layer to a bottom layer of the conductor layer; or the slotted structure extends from the top layer of the conductor layer to any position between the top layer and the bottom layer of the conductor layer. For example, the slotted structure 401 formed between 101 and 301 extends from the top layer to 605, the slotted structure 402 formed between 102 and 302 extends from the bottom layer to 606, the slotted structure 403 formed between 201 and 303 extends from the top layer to 605, and the slotted structure 402 formed between 202 and 304 extends from the bottom layer to 606.

The present disclosure is described in detail below with reference to specific examples:

Three elements of the crosstalk are an interference source, a coupling path and a victim signal. From the perspective of the coupling path, the methods for suppressing the crosstalk include: increasing a distance between the interference source and the victim signal, and adding a ground isolated via-hole between the interference source and the victim signal.

For a BGA chip in a fixed package, the former may not reduce the crosstalk by increasing a distance between a fan-out via-hole of the victim signal and a fan-out via-hole of the interference signal, while the latter may not add the isolation ground via-hole between the fan-out via-hole of the victim signal and the fan-out via-hole of the interference signal due to space constraints in some high-density packages. With the further increase of the rate, the limitations of these two methods become more and more obvious.

In order to solve the above problems, this embodiment provides a PCB via-hole crosstalk suppression device: a slotting design is provided between the victim signal via-hole and the ground via-hole and between the interference signal via-hole and the ground via-hole on the PCB, and the high permittivity dielectric is filled after slotting. The high permittivity dielectric refers to the dielectric with permittivity higher than that of PCB. Since the mutual capacitance per unit length between the signal via-hole and the ground via-hole increases, the signal and the ground are coupled more tightly from the angle of electromagnetic field, thus greatly improving return and reducing an energy coupling between the interference signal via-hole and the victim signal via-hole, and ultimately reducing the crosstalk.

This embodiment mainly adopts the following technical solutions:

The crosstalk may be divided into a near-end crosstalk and a far-end crosstalk from the position relationship between the interference source and the victim source. A near-end crosstalk coefficient and a far-end crosstalk coefficient are shown in Formula 1 and Formula 2:

$$\mathrm{NEXT} = \frac{1}{4}\left(\frac{C_{mL}}{C_L} + \frac{L_{mL}}{L_L}\right)\dots\dots\dots\dots\dots\dots\dots\dots\dots\dots\dots\dots\dots\dots\dots\dots\dots\dots\dots (1)$$

Herein, NEXT is the near-end crosstalk coefficient, CmL is a mutual capacitance per unit length, CL is a capacitance per unit length on a signal path, LmL is a mutual inductance per unit length, and LL is an inductance per unit length on the signal path.

$$\mathrm{FEXT} = \frac{Len}{RT} \times \frac{1}{2v} \times \left(\frac{C_{mL}}{C_L} - \frac{L_{mL}}{L_L}\right)\dots\dots\dots\dots\dots\dots\dots\dots\dots\dots\dots\dots\dots\dots (2)$$

Herein, FEXT is the far-end crosstalk coefficient, Len is a coupling length between two signal channels, RT is a signal rising time, v is a signal transmission rate on a transmission line, CmL is the mutual capacitance per unit length, CL is the capacitance per unit length on the signal path, LmL is the mutual inductance per unit length and LL is the inductance per unit length on the signal path.

It can be seen from Formula 1 and Formula 2 that both the near-end crosstalk and the far-end crosstalk are proportional to the mutual capacitance per unit length (CmL). The larger the mutual capacitance per unit length, the greater the near-end crosstalk and the far-end crosstalk.

The mutual capacitance per unit length is proportional to the permittivity of the dielectric. The smaller the permittivity, the smaller the mutual capacitance per unit length.

This embodiment adopts the following technology to improve the crosstalk between signals based on the above-mentioned principle: a slotting design is provided between the victim signal via-hole and the ground via-hole and between the interference signal via-hole and the ground via-hole on the PCB, and the high permittivity dielectric is filled after slotting. The high permittivity dielectric refers to the dielectric with higher permittivity than that of PCB. Since the mutual capacitance per unit length between the signal via-hole and the ground via-hole increases, the signal and ground are coupled more tightly from the angle of electromagnetic field, thus greatly improving return of signal and reducing the energy coupling between the interference signal via-hole and the victim signal via-hole, and ultimately reducing the crosstalk.

The following contents are specifically included.

A high-speed differential signal usually needs to adopt a differential via-hole on the PCB to change a layer, and a crosstalk between the differential via-holes may be suppressed by the present disclosure. Take a ten layers circuit board in FIG. 1 as an example, the circuit board body comprises conductors 601-608 and dielectrics 701-709, and 301-304 are the ground via-holes. The following steps are adopted to suppress the crosstalk of the differential via-holes.

In S101, 101 and 102 are determined as the layer-changing via-holes for victim differential signal.

In S102, 201 and 202 are determined as the layer-changing via-holes for interference differential signal.

In S103, a slotted structure 401 is formed between 101 and 301, a slotted structure 402 is formed between 102 and 302, a slotted structure 403 is formed between 201 and 303 and a slotted structure 404 is formed between 202 and 304.

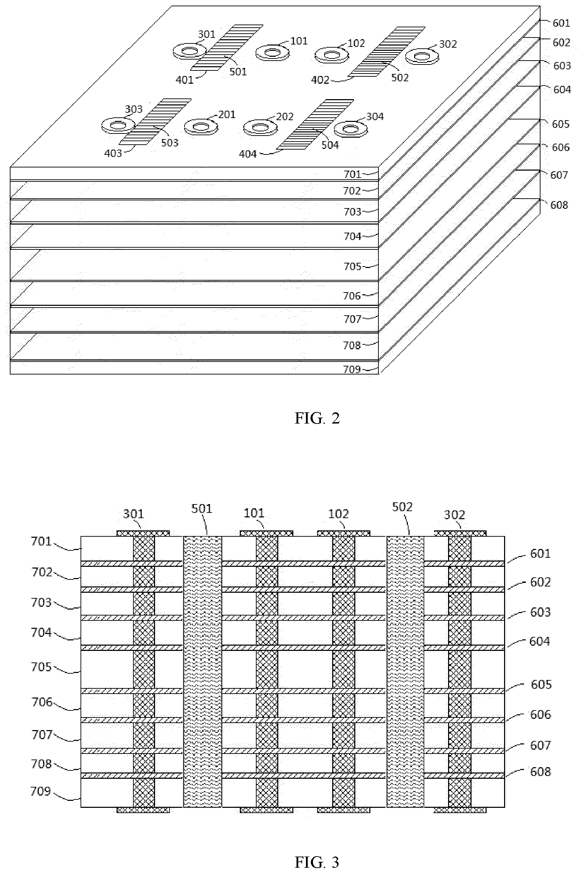

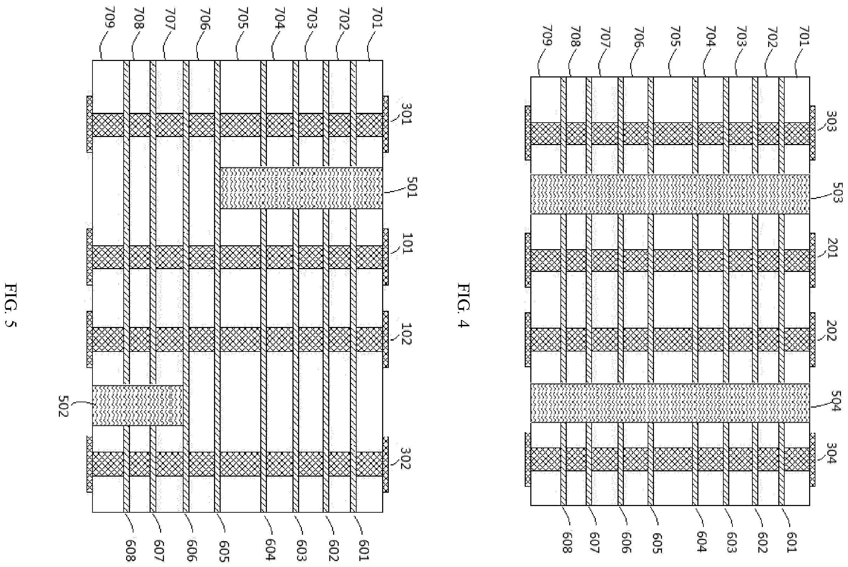

In S104, high permittivity dielectrics 501-504 are filled in the slotted structures 401-404 respectively, as shown in FIGs. 2, 3 and 4 (FIG. 3 and FIG. 4 are cross-sectional views).

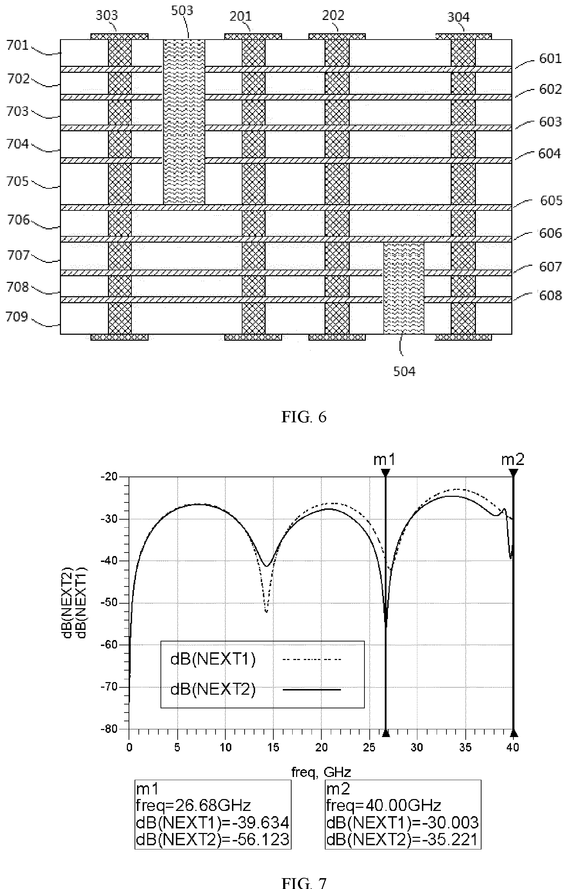

After adopting the above embodiments, the energy coupling between the via-holes for victim differential signal 101, 102 and the layer-changing via-holes for interference differential signal 201, 202 is obviously reduced. As shown in FIG. 7, the dotted line is the curve of near-end crosstalk changing with frequency before improvement, and the solid line is the curve of near-end crosstalk changing with frequency after improvement. It can be seen that the near-end crosstalk is obviously reduced at high frequency side after improvement.

In addition, the crosstalk between the high-speed signal differential via-holes is suppressed by the design shown in FIG. 4 and FIG. 5, which includes the following steps.

In S201, 101 and 102 are determined as the layer-changing via-holes for victim differential signal.

In S202, 201 and 202 are determined as the layer-changing via-holes for interference differential signal.

In S203, a slotted structure 401 from the top layer to 605 is formed between 101 and 301, a slotted structure 402 from the bottom layer to 606 is formed between 102 and 302, a slotted structure 403 from the top layer to 605 is formed between 201 and 303, and a slotted structure 402 from the bottom layer to 606 is formed between 202 and 304. Another example is as shown in FIGs. 5 and 6.

In S204, high permittivity dielectrics 501-504 are filled in the slotted structures 401-404 respectively.

After the above embodiments are adopted, the permittivity between the via-holes for victim differential signal 101, 102 and the ground via-holes, as well as between the layer-changing via-holes for interference differential signal 201, 202 and the ground via-holes is increased, which enhances the return of the signal via-holes, thereby significantly reducing the energy coupling between the victim via-hole and the interference signal via-hole and effectively improving the crosstalk.

To sum up, the above-described solutions are beneficial to improve the crosstalk between the interfering signal and the victim signal at a fixed position. Generally, the method to reduce the crosstalk is to increase the distance between the interference signal and the victim signal. However, for chips in the fixed package, such as BGA chips, the distance between the fan-out via-hole for victim signal and the fan-out via-hole for interference signal is fixed, so the crosstalk may not be reduced by increasing the distance therebetween. However, the present disclosure may reduce the crosstalk without increasing the distance therebetween, which is beneficial to improve the crosstalk of high-speed and high-density single board. An effective way to reduce the crosstalk between via-holes on the PCB is to increase the ground isolated via-holes between the via-holes. However, for the high-speed and high-density single board, the distance between the interference signal and the victim signal is small in many cases, and the ground isolated via-holes may not be used for isolation, otherwise serious quality problems such as short circuit may occur. In the present disclosure, the crosstalk of the interference signal to the victim signal may be reduced by slotting and filling high permittivity dielectric, which reduces the processing difficulty and reliability.

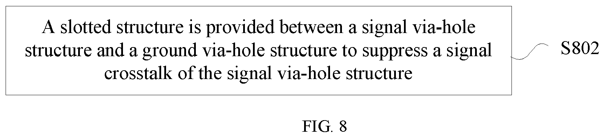

In an embodiment of the present disclosure, a signal crosstalk suppression method is further provided. FIG. 8 is a flowchart of the signal crosstalk suppression method according to an embodiment of the present disclosure. As shown in FIG. 8, the flow includes the following steps.

In S802, a slotted structure is provided between a signal via-hole structure and a ground via-hole structure to suppress a signal crosstalk of the signal via-hole structure.

Herein, the signal via-hole structure and the ground via-hole structure are configured in a circuit board. The signal via-hole structure is configured to transmit a signal by changing a layer, and the ground via-hole structure is configured to return the signal transmitted from the signal via-hole structure.

Through the above steps, since the slotted structure is configured between the signal via-hole structure and the ground via-hole structure, the crosstalk may also be reduced even in BGA chips in a fixed package and high-speed and high-density single boards. Therefore, the problem of via-hole crosstalk suppression may be solved, and the effect of reducing the crosstalk of an interference signal to a victim signal may be achieved.

Optionally, an execution subject of the above steps may be a terminal, etc., but is not limited thereto.

Optionally, the circuit board body includes: a conductor layer, including a plurality of conductors; and a dielectric layer, including a plurality of dielectrics. The conductors included in the conductor layer and the dielectrics included in the dielectric layer are provided in the circuit board body in a cross-stacked manner.

Optionally, the signal via-hole structure includes: a layer-changing via-hole for victim differential signal, configured for a layer-changing transmission for a victim differential signal; and a layer-changing via-hole for interference differential signal, configured for a layer-changing transmission for an interference differential signal.

Optionally, the ground via-hole structure includes a plurality of ground via-holes.

Optionally, the slotted structure is provided between the signal via-hole structure and the ground via-hole structure. The slotted structure includes a plurality of slots, and the plurality of slots are respectively provided between the layer-changing via-hole for victim differential signal and the ground via-hole, and between the layer-changing via-hole for interference differential signal and the ground via-hole.

Optionally, the slotted structure is filled with a high permittivity dielectric. The high permittivity dielectric includes a dielectric with a higher permittivity than a permittivity of the circuit board body.

Optionally, one of the following is included: the slotted structure extends from a top layer of the conductor layer to a bottom layer of the conductor layer; or the slotted structure extends from the top layer of the conductor layer to any position between the top layer and the bottom layer of the conductor layer.

From the description of the above embodiments,, those skilled in the art may clearly understand that the method according to the above embodiments may be implemented by means of a software plus a necessary general hardware platform, and of course, may further be implemented by means of a hardware, but the former is a better embodiment in many cases. Based on such understanding, the essence of the technical solution of the present disclosure or the part contributing to the existing technology may be embodied in the form of a software product. The computer software product may be stored in a storage medium (such as a ROM/RAM, a magnetic disk, an optical disk), and includes several instructions to cause a terminal device (which may be a mobile phone, a computer, a server, or a network device, etc.) to execute the methods described in various embodiments of the present disclosure.

An embodiment of the present disclosure further provides a storage medium in which a computer program is stored, and the computer program is set to execute the steps in any of the above method embodiments at runtime.

Optionally, in this embodiment, the storage medium may be set to store the computer program set to execute the above steps.

Optionally, in this embodiment, the above-mentioned storage media may include, but are not limited to, various media that may store computer programs, such as U disk, Read-Only Memory (ROM), Random Access Memory (RAM), mobile hard disk, magnetic disk or optical disk.

An embodiment of the present disclosure further provides an electronic device, which includes a memory and a processor, where the memory stores a computer program, and the processor is set to run the computer program to execute the steps in any of the above method embodiments.

Optionally, the electronic device may further include a transmission equipment and an input/output equipment; the transmission equipment is connected with the above processor and the input/output equipment is connected with the above processor.

Optionally, in this embodiment, the processor may be set to execute the above steps through the computer program.

Optionally, the specific examples in this embodiment may refer to the examples described in the above embodiments and optional implementation modes, and details are not described herein again.

It is obvious that those skilled in the art should understand that each of the above-described modules or steps of the present disclosure may be implemented by a general computing device. They may be concentrated on a single computing device or distributed on a network composed of a plurality of computing devices. Alternatively, they may be implemented by program codes executable by the computing devices, so that they may be stored in a storage device for executing by the computing device, and in some cases, the steps shown or described may be executed in a different order from here. Alternatively, they may be made into various integrated circuit modules, or a plurality of modules or steps among them may be made into a single integrated circuit module. Thus, the present disclosure is not limited to any particular combination of hardware and software.

The above description is only preferred embodiments of the present disclosure, and is not intended to limit the present disclosure. For those skilled in the art, the present disclosure may have various modifications and changes. Any modification, equivalent substitution, improvement, etc. made within the principle of the present disclosure shall be contained within the protection scope of the present disclosure.

Industrial applicability

As described above, the circuit board, the signal crosstalk suppression method, the storage medium and the electronic device provided by the embodiments of the present disclosure have the following beneficial effects: since the slotted structure is provided between the signal via-hole structure and the ground via-hole structure, the crosstalk may also be reduced even in BGA chips in a fixed package and high-speed and high-density single boards. Therefore, the problem of via-hole crosstalk suppression is solved, and the effect of reducing the crosstalk of an interference signal to a victim signal is achieved.

**Claims**

1. A circuit board, comprising:

   a circuit board body, provided with a signal via-hole structure and a ground via-hole structure, wherein the signal via-hole structure is configured to transmit a signal by changing a layer, and the ground via-hole structure is configured to return a signal transmitted from the signal via-hole structure; and
   a slotted structure, provided between the signal via-hole structure and the ground via-hole structure, and configured to suppress a signal crosstalk of the signal via-hole structure.

2. The circuit board according to claim 1, wherein the circuit board body comprises:

   a conductor layer, comprising a plurality of conductors; and
   a dielectric layer, comprising a plurality of dielectrics;
   wherein the plurality of conductor comprised in the conductor layer and the plurality of dielectric comprised in the dielectric layer are configured in the circuit board body in a cross-stacked manner.

3. The circuit board according to claim 1, wherein the signal via-hole structure comprises:

   a layer-changing via-hole for victim differential signal, configured for a layer-changing transmission for a victim differential signal; and
   a layer-changing via-hole for interference differential signal, configured for a layer-changing transmission for an interference differential signal.

4. The circuit board according to claim 3, wherein the ground via-hole structure comprises a plurality of ground via-holes.

5. The circuit board according to claim 4, wherein the slotted structure is provided between the signal via-hole structure and the ground via-hole structure, wherein:
   the slotted structure comprises a plurality of slots, and the plurality of slots are respectively provided between the layer-changing via-hole for victim differential signal and the ground via-hole, and between the layer-changing via-hole for interference differential signal and the ground via-hole.

6. The circuit board according to claim 1, wherein the slotted structure is filled with a high permittivity dielectric, wherein the high permittivity dielectric comprises a dielectric with a higher permittivity than a permittivity of the circuit board body.

7. The circuit board according to claim 2, comprising one of the following:

   the slotted structure extending from a top layer of the conductor layer to a bottom layer of the conductor layer; and
   the slotted structure extending from the top layer of the conductor layer to any position between the top layer and the bottom layer of the conductor layer.

8. A signal crosstalk suppression method, comprising:

   providing a slotted structure between a signal via-hole structure and a ground via-hole structure, to suppress a signal crosstalk of the signal via-hole structure;
   wherein the signal via-hole structure and the ground via-hole structure are provided in a circuit board; the signal via-hole structure is configured to transmit a signal by changing a layer, and the ground via-hole structure is configured to return a signal transmitted from the signal via-hole structure.

9. A storage medium, storing a computer program, wherein the computer program is set to execute the method described in claim 8 at runtime.

10. An electronic device, comprising a memory and a processor, wherein the memory stores a computer program, and the processor is set to run the computer program to execute the method described in claim 8.

FIG. 1

FIG. 2

FIG. 3

303 503 201 202 504 304

701 601
702 602
703 603
704 604
705 605
706 606
707 607
708 608
709

FIG. 4

301 501 101 102 302

701 601
702 602
703 603
704 604
705 605
706 606
707 607
708 608
709

502

FIG. 5

FIG. 6

| m1 | m2 |
|---|---|
| freq=26.68GHz | freq=40.00GHz |
| dB(NEXT1)=-39.634 | dB(NEXT1)=-30.003 |
| dB(NEXT2)=-56.123 | dB(NEXT2)=-35.221 |

FIG. 7

A slotted structure is provided between a signal via-hole structure and a ground via-hole structure to suppress a signal crosstalk of the signal via-hole structure

S802

FIG. 8

## INTERNATIONAL SEARCH REPORT

| International application No. |
| --- |
| **PCT/CN2019/104929** |

### A. CLASSIFICATION OF SUBJECT MATTER

H05K 1/02(2006.01)i

According to International Patent Classification (IPC) or to both national classification and IPC

### B. FIELDS SEARCHED

Minimum documentation searched (classification system followed by classification symbols)

H05K

Documentation searched other than minimum documentation to the extent that such documents are included in the fields searched

Electronic data base consulted during the international search (name of data base and, where practicable, search terms used)

CNPAT, CNKI, WPI, EPODOC: 过孔, 信号, 地, 槽, 空, 串扰, hole, signal, ground, slot, gap, space, crosstalk

### C. DOCUMENTS CONSIDERED TO BE RELEVANT

| Category* | Citation of document, with indication, where appropriate, of the relevant passages | Relevant to claim No. |
| --- | --- | --- |
| X | CN 102714917 A (MOLEX INCORPORATED) 03 October 2012 (2012-10-03) description, paragraphs [0014]-[0020], and figures 1-5 | 1-10 |
| A | CN 107995776 A (WUHAN TELECOMMUNICATION DEVICES CO., LTD.) 04 May 2018 (2018-05-04) entire document | 1-10 |
| A | CN 101455129 A (INTEL CORPORATION) 10 June 2009 (2009-06-10) entire document | 1-10 |
| A | CN 2886982 Y (HUAWEI TECHNOLOGIES CO., LTD.) 04 April 2007 (2007-04-04) entire document | 1-10 |
| A | CN 108076580 A (ZTE CORPORATION) 25 May 2018 (2018-05-25) entire document | 1-10 |
| A | US 2017025345 A1 (NVIDIA CORPORATION) 26 January 2017 (2017-01-26) entire document | 1-10 |

☐ Further documents are listed in the continuation of Box C.    ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **18 November 2019** | **27 November 2019** |

| Name and mailing address of the ISA/CN | Authorized officer |
| --- | --- |
| **China National Intellectual Property Administration** **No. 6, Xitucheng Road, Jimenqiao Haidian District, Beijing 100088** **China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2019/104929**

| Patent document cited in search report | | | Publication date (day/month/year) | Patent family member(s) | | | Publication date (day/month/year) |
|---|---|---|---|---|---|---|---|
| CN | 102714917 | A | 03 October 2012 | WO | 2011063105 | A2 | 26 May 2011 |
| | | | | JP | 2013511849 | A | 04 April 2013 |
| | | | | US | 2013077268 | A1 | 28 March 2013 |
| | | | | TW | 201127232 | A | 01 August 2011 |
| CN | 107995776 | A | 04 May 2018 | None | | | |
| CN | 101455129 | A | 10 June 2009 | CN | 101455129 | B | 13 June 2012 |
| | | | | US | 2008001286 | A1 | 03 January 2008 |
| | | | | US | 7781889 | B2 | 24 August 2010 |
| | | | | TW | 200814277 | A | 16 March 2008 |
| | | | | TW | I349990 | B | 01 October 2011 |
| | | | | WO | 2008003021 | A2 | 03 January 2008 |
| CN | 2886982 | Y | 04 April 2007 | None | | | |
| CN | 108076580 | A | 25 May 2018 | None | | | |
| US | 2017025345 | A1 | 26 January 2017 | TW | I658556 | B | 01 May 2019 |
| | | | | US | 10032710 | B2 | 24 July 2018 |
| | | | | DE | 102016213044 | A1 | 26 January 2017 |
| | | | | TW | 201712833 | A | 01 April 2017 |

Form PCT/ISA/210 (patent family annex) (January 2015)